# EUROPEAN PATENT SPECIFICATION

(11) **EP 2 982 643 B1**
(45) Date of publication and mention of the grant of the patent: **12.04.2017**
(21) Application number: 15178744.7
(22) Date of filing: 28.07.2015
(51) Int. Cl.: B81C 1/00, B81B 7/00

(54) **MONOLITHIC INTEGRATION OF STRESS ISOLATION FEATURES IN A MICROELECTROMECHANICAL SYSTEM (MEMS) STRUCTURE**
MONOLITHISCHE INTEGRATION VON BELASTUNGSISOLATIONSMITTEL IN EINER MIKROSYSTEM (MEMS)-STRUKTUR
INTÉGRATION MONOLITHIQUE DE CARACTÉRISTIQUES D'ISOLATION DES CONTRAINTES DANS UNE STRUCTURE DE SYSTÈME MICROÉLECTROMÉCANIQUE (MEMS)

(30) Priority: 06.08.2014 US 201414453155
(43) Date of publication of application: 10.02.2016
(73) Proprietor: Honeywell International Inc., Morris Plains, NJ 07950 (US)
(72) Inventor: Lodden, Grant H., Morristown, New Jersey 07962-2245 (US); Supino, Ryan, Morristown, New Jersey 07962-2245 (US)
(74) Representative: Houghton, Mark Phillip

(56) References cited:
- EP-A2- 2 455 329
- EP-A2- 2 700 614

## Description

### Background

Various microelectromechanical (MEMS) devices are vulnerable to stresses exerted by their surrounding package structure, especially those with capacitive readouts, diaphragm elements and resonant structures. For example, these stresses may arise due to the distinct physical properties of dissimilar materials in the package and sensor. As a result, changes in temperature, ambient pressure, and humidity lead to degradation in the performance of the MEMS device. Further, device performance can also be degraded over the life of the device due to mechanical drift, e.g., due to mechanical creep of die bonds.

One traditional method of isolating a MEMS device from package-induced stresses is to fabricate an interface layer between the package and MEMS device. The interface layer contains a series of flexible beams that deflect under package-induced stresses, minimizing the effect on the performance of the MEMS device. However, such a technique requires fabrication of an additional layer. This increases the complexity, cycle time and cost to the packaged device. Alternatively, these features could be fabricated in the existing MEMS structure but conventional approaches to such fabrication are not readily compatible with other aspects of the MEMS fabrication process. EP 2 700 614 discloses methods for fabricating mems structures by etching the sacrificial features embedded in glass. EP 2 455 329 discloses a vibration interposition intoposer die.

### Summary

A microelectromechanical (MEMS) structure is provided. In one embodiment, the MEMS structure includes a glass substrate layer containing at least one embedded stress isolation feature. The glass substrate also includes at least one bump bond site configured for coupling the MEMS structure to a package. The MEMS structure also includes a semiconductor device layer, formed on the glass substrate layer, that includes a MEMS sensor. The MEMS structure also includes a top glass layer disposed on the semiconductor device layer.

### Brief Description of the Drawings

Figures 1-8 are perspective views of a MEMS structure with integrated stress isolation features at various stages of production according to one embodiment of the present invention.
Figure 9 is a side view of the embodiment of the MEMS structure of Figures 1-8.
Figure 10 is a perspective view of the embodiment of Figures 1-9 that illustrates the placement of bump bonds for the MEMS structure.
Figures 11-14 are perspective views of another embodiment of a MEMS structure with integrated stress isolation features at various stages of production according to another embodiment of the present invention.
Figure 15 is a top view of the embodiment of the MEMS structure of Figures 11-14.
Figure 16 is a top view of the embodiment of Figures 11-14.

### Detailed Description

Embodiments of the present invention integrate or embed a stress isolation structure or feature into a glass layer in a microelectromechanical device architecture or structure. Advantageously, embodiments of the present invention are fabricated with embedded sacrificial material in the glass layer that can be etched away to form patterned glass features that are integrated in a monolithic glass layer. These glass features that remain after the sacrificial material is removed are referred to herein as stress isolation structures or features. For purposes of this specification, the term "stress isolation feature" or "stress isolation structure" means a set of compliant flexures which have enough stiffness so that the overall structure is relatively robust under various kinds of vibration or acceleration conditions but is compliant enough so that the feature absorbs stresses exerted by the device package. In one example, a stress isolation structure is a set of beams formed from a material that is sufficiently rigid such as glass. In other embodiments, the stress isolation feature takes other shapes appropriate to isolating the MEMS device from the stresses induced by the package that houses the device. As used herein, the term "sacrificial feature" refers to a feature formed in a layer of material that will be removed prior to completion of the process of forming the MEMS device. In essence, the sacrificial feature acts as a mold to define the structure (shape, size and location) of the stress isolation feature in the glass layer of the MEMS device.

The use of sacrificial features in a glass layer of a MEMS device enables the formation of integrated or embedded stress isolation features in the MEMS device architecture. Traditional methods of patterning glass include wet chemical etch processes and deep reactive ion etching. These methods are often incompatible with various materials in the MEMS device architecture, and are thus undesirable as a means to fabricate stress isolation features in a glass layer of a MEMS device. Advantageously, with the sacrificial-material process, the stress isolation features can be defined prior to patterning the glass with recesses and metallization for the MEMS device. To accomplish this, the sacrificial features are formed with a material having a melting or softening temperature above that of glass. Thus, an array of materials are available for use. In one manifestation, a semiconductor material such as intrinsic silicon is chosen as the sacrificial material. In addition to having a high melting or softening point, silicon is easy to micromachine via deep reactive ion etching enabling the formation of the high aspect ratio features that are required for this application. Furthermore, the sacrificial material is engineered to be compatible with subsequent MEMS process steps. Following the fabrication of the MEMS device, the embedded sacrificial features can be removed with a suitable etchant thereby leaving the embedded stress isolation features in the glass layer.

Advantageously, the technique is applicable to any MEMS structure containing a glass layer in its architecture. The glass layer, in this manifestation, is therefore a rigid wafer with embedded stress isolation features conducive to traditional MEMS processing techniques.

### First Embodiment

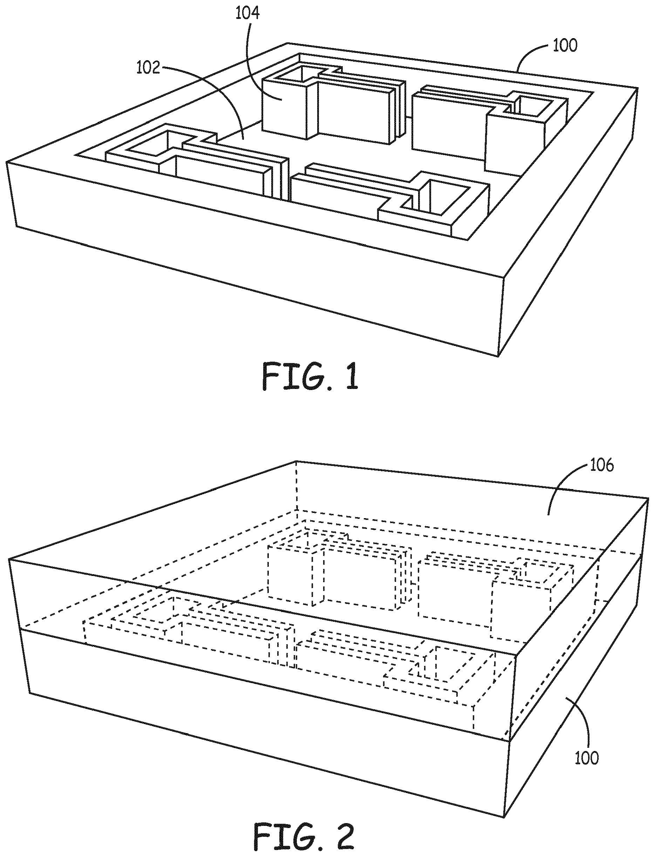

Figures 1-10 illustrate the fabrication of a first embodiment of a MEMS structure with stress isolation features that are embedded or integrated into a glass layer of the MEMS structure. This MEMS structure includes three main layers: a bottom glass layer, a semiconductor layer and a top glass layer. The bottom glass layer includes the embedded stress isolation features. In one embodiment, the MEMS structure includes a MEMS resonator device where the semiconductor layer forms the resonant structure and comb drives, and the top and bottom glass layers form the stress isolation structure and other electrodes.

As shown in Figure 1, the process for fabricating the MEMS structure begins with a layer of sacrificial material 100. In one embodiment, layer 100 is a layer of semiconductor material such as silicon. In other embodiments, other materials are used that have a melting or softening temperature above that of glass. Using a deep reactive ion etching process (DRIE), a pattern is etched in layer 100. This pattern includes voids 102 and islands 104. The islands 104 are also referred to as sacrificial features as defined above. In conjunction with the voids 102, the sacrificial features 104 act as a mold for the later formation of the stress isolation features as described in more detail below.

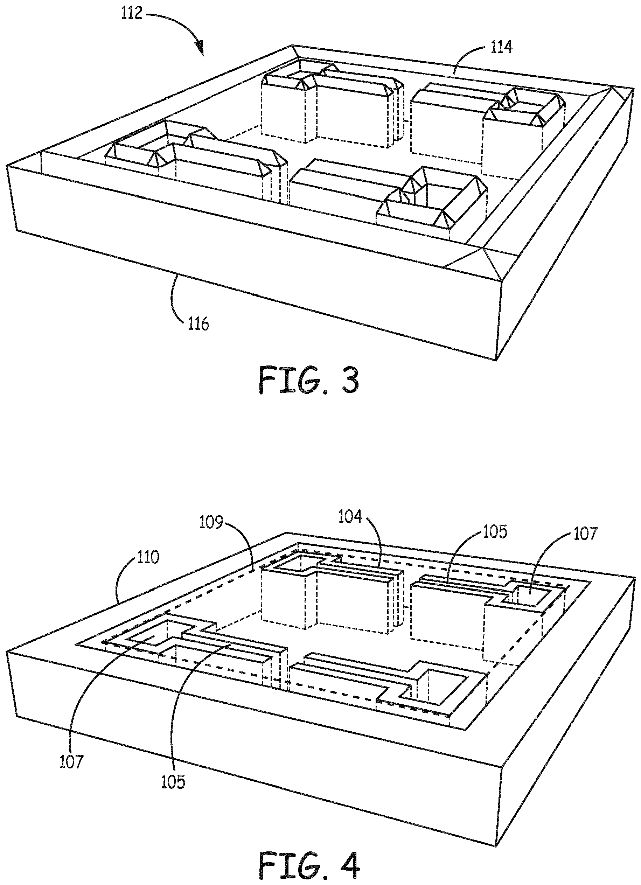

With the preparation of the sacrificial layer 100, the bottom glass layer 110 of the MEMS structure is ready to be formed with its embedded stress isolation features. A glass wafer 106 is bonded to the sacrificial layer 100 in an atmosphere that approximates a vacuum as shown in Figure 2. The structure in Figure 2 is heated beyond the glass softening point. This heating of glass wafer 106 in a vacuum forms the bottom glass layer 110 of the MEMS structure as the glass of glass wafer 106 melts or softens and is pulled into the pattern of voids 102 and around the islands or sacrificial features 104 in sacrificial layer 100 to form structure 112 as shown in Figure 3. Structure 112 is polished from sides 114 and 116 to remove the handle material and create a smooth glass substrate. As a result, sacrificial features 104 are embedded or integrated in bottom glass layer 110 as shown in Figure 4. In this embodiment, the sacrificial features 104 define beams 105 and pads 107. Beams 105 are the so-called stress isolation features in this embodiment. In the embodiment shown, glass layer 110 includes four pads 107 that are dispersed in a pattern in layer 110 to form a square 109. A beam 105 extends from each pad 107. Two beams 105 extend from adjacent pads 107 along one side of the square 109. Another two beams 105 extend from the other two pads 107 along another, opposite side of square 109.

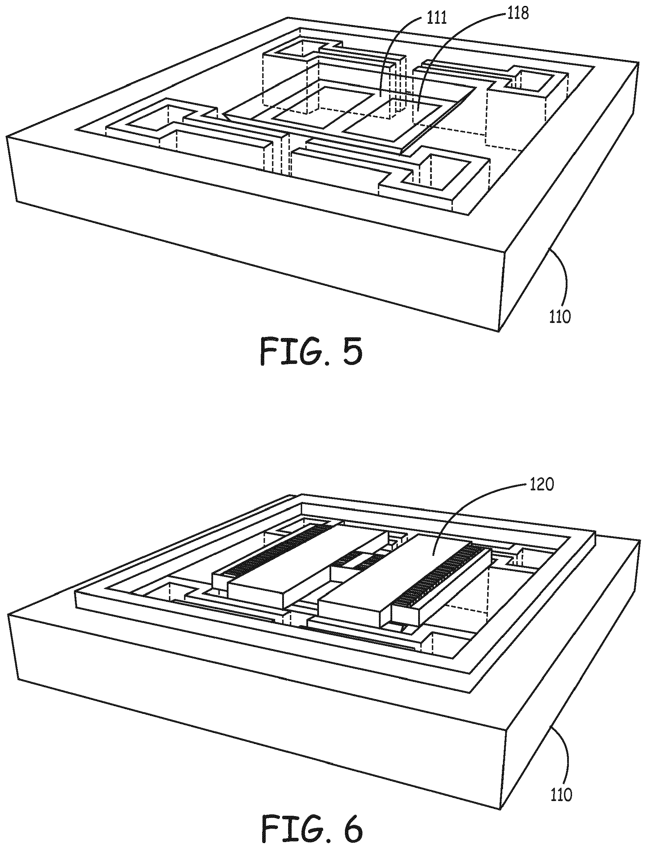

As mentioned above, the MEMS structure also includes a semiconductor layer. The bottom glass layer 110 is prepared for receiving the semiconductor layer by patterning and etching recesses 111 in the glass layer 110. The recesses 111 in bottom glass layer 110 are created for the metallization portion of MEMS structure. Bottom glass layer 110 also receives mesa areas 118 that form regions for bonding to a semiconductor suspension layer 120 of the MEMS structure as shown in Figure 5. The semiconductor suspension layer 120 is patterned using DRIE. The semiconductor suspension layer, in one embodiment, is formed using degenerately doped epitaxial silicon on a handle wafer or a highly doped silicon wafer bonded to a low doped silicon wafer and polished to produce a 25-100 micron device or semiconductor layer. This semiconductor layer 120 is bonded to the bottom glass wafer 110 and the silicon handle layer is dissolved or etched away leaving only the device or semiconductor layer 120 as shown in Figure 6.

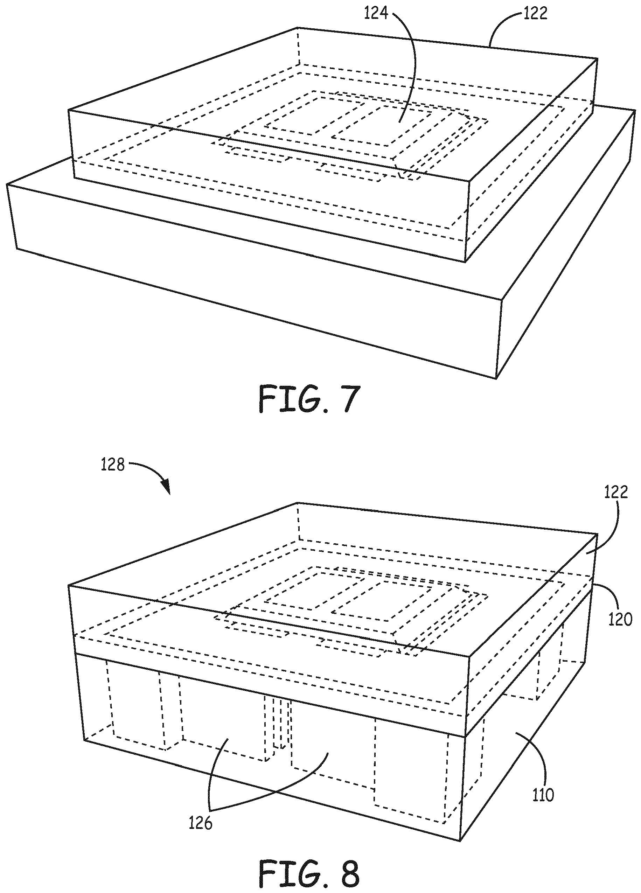

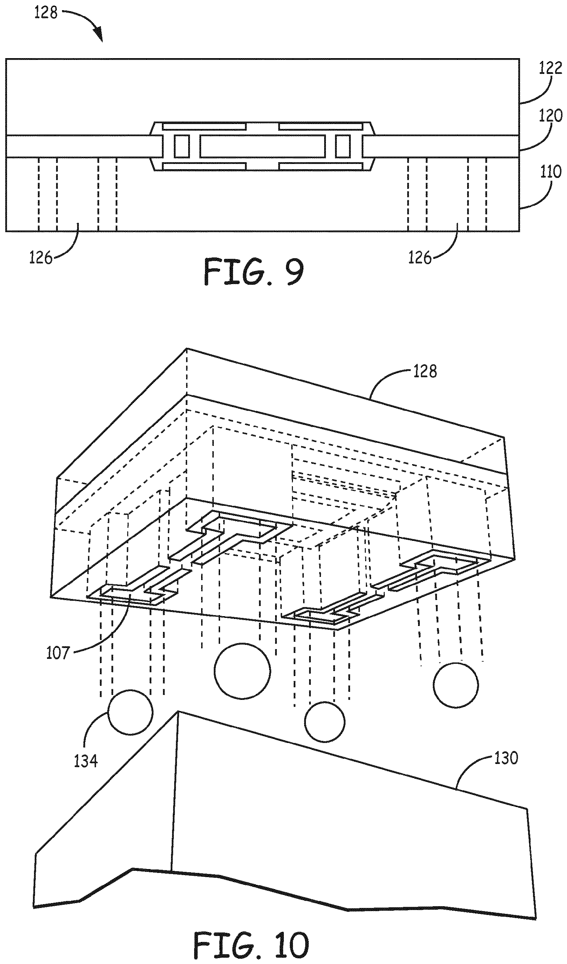

The MEMS device is completed with the addition of the top glass layer and removal of the sacrificial features. As shown in Figure 7, a glass wafer 122 containing patterned metallization and recesses 124 is bonded to the patterned semiconductor layer 120. Using a wet etch, the sacrificial features 104 are removed from bottom glass layer 110 and form the stress isolation structures 126 in the bottom glass layer 110 as shown in Figure 8. In one embodiment, low doped silicon is used as the sacrificial material. This allows removal of the sacrificial features using EDP without etching away the (degenerately doped) semiconductor or device layer 120. A cross-section of the MEMS device 128 is shown in Figure 9. Advantageously, the high aspect ratio, smooth side walls and precise feature control for this type of glass patterning permits the fabrication of various types of stress isolation structures into a glass layer in the MEMS architecture.

Once formed, MEMS device 128 is inserted into a package or housing using an appropriate die attach method. For example, in one embodiment, MEMS device 128 is bump bonded to a package 130 on stress isolation structures fabricated in the glass. For example, bump bonds 134 are formed on pads 107 to mount the MEMS device 128 in package 130 as shown in Figure 10. In other embodiments, other die attach methods are used such as, for example, MEMS device 128 is secured in package 130 using epoxy or other adhesive, eutectic bonding, soft solder or other die attach method.

### Second Embodiment

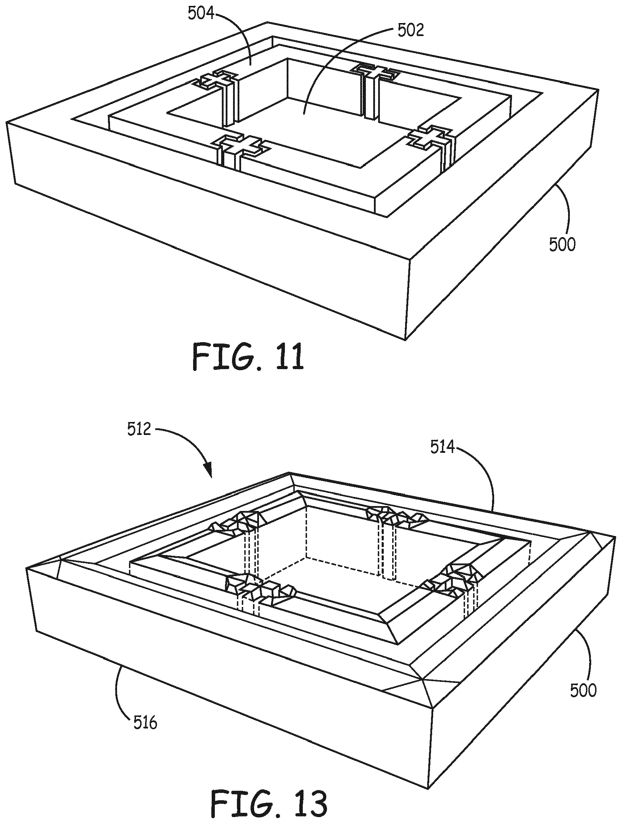

Figures 11-16 illustrate a second embodiment of a MEMS structure with a different layout of stress isolation features. For simplicity, only the formation of the bottom glass layer of this MEMS structure is explained in detail as the balance of the process is the same as the first embodiment. In this embodiment, the MEMS structure also includes three main layers: a bottom glass layer, a semiconductor layer and a top glass layer. The bottom glass layer includes a different embedded stress isolation feature that is based on a frame that surrounds a center glass pad.

As shown in Figure 11, the process for fabricating the MEMS structure begins with a layer of sacrificial material 500. In one embodiment, layer 500 is a layer of semiconductor material such as silicon. In other embodiments, other materials are used that have a melting or softening temperature above that of glass. Using a dry reactive ion etching process (DRIE), a pattern is etched in layer 500. This pattern includes voids 502 and islands 504. The islands 504 are also referred to as sacrificial features as defined above. In conjunction with the voids 502, the sacrificial features act as a mold for the later formation of the stress isolation features as described in more detail below.

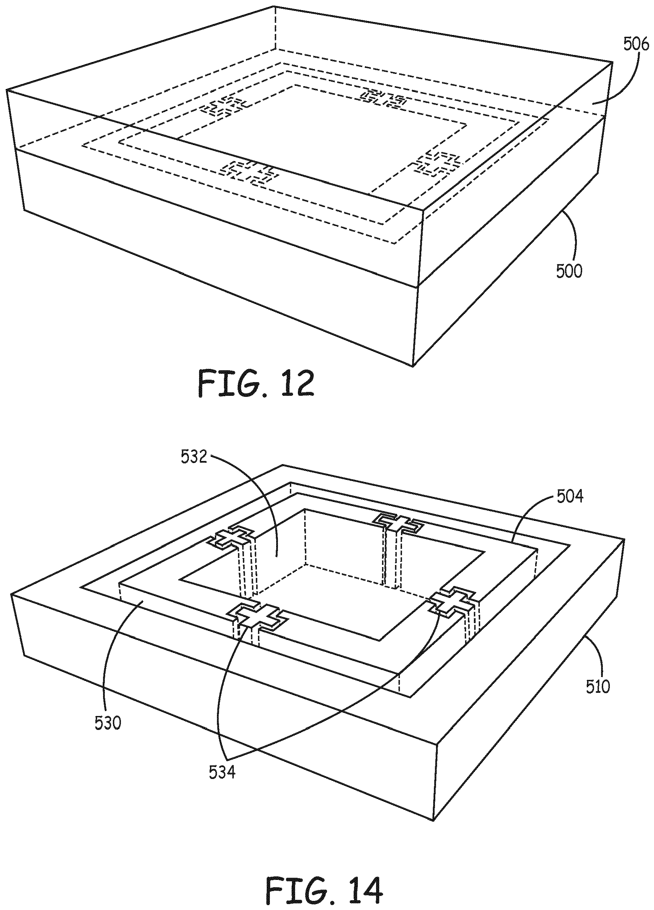

With the preparation of the sacrificial layer 500, the bottom glass layer 510 of the MEMS structure is ready to be formed with its embedded stress isolation features. A glass wafer 506 is bonded to the sacrificial layer 500 in an atmosphere that approximates a vacuum as shown in Figure 12. The structure in Figure 12 is heated beyond the glass softening point. This heating of glass wafer 504 in a vacuum forms the bottom glass layer 510 of the MEMS structure as the glass of glass wafer 504 melts or softens and is pulled into the pattern of voids 502 and around the islands or sacrificial features 504 in sacrificial layer 500 to form structure 512 as shown in Figure 13. Structure 512 is polished from sides 514 and 516 to remove the handle material and create a smooth glass substrate. As a result, sacrificial features 504 are embedded or integrated in bottom glass layer 510 as shown in Figure 14. In this embodiment, the sacrificial features 504 define a glass frame 530 that extends around a perimeter of the MEMS structure. The glass frame 530 surrounds a center glass plate 532 and is coupled to the glass frame 530 by a plurality of glass suspensions 534.

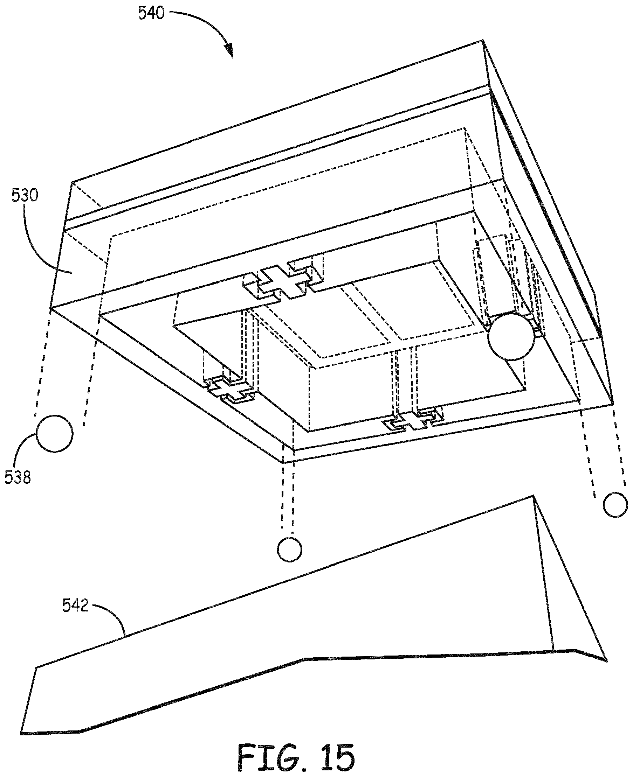

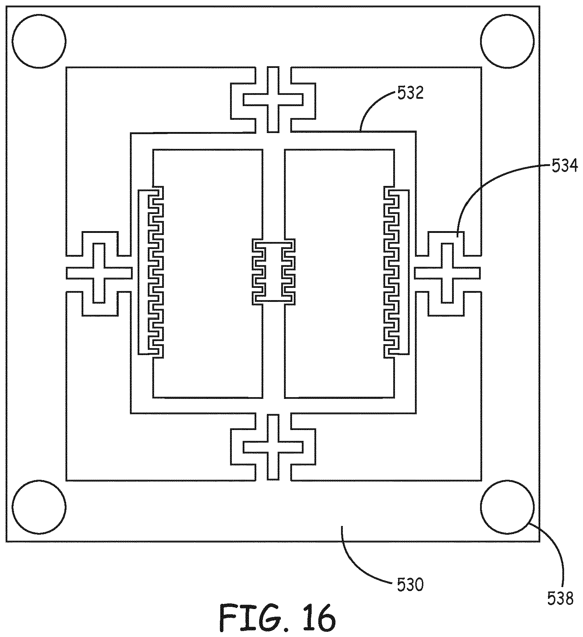

Once formed, MEMS device 540 is inserted into a package using an appropriate die attach method as shown in Figure 15. For example, in one embodiment, MEMS device 540 is bump bonded to a package 542 on stress isolation structures fabricated in the glass. For example, bump bonds 538 are formed on frame 530 to mount the MEMS device 540 in package 542 as shown in Figure 15. A top view of MEMS device 540 is shown in Figure 16. In other embodiments, other die attach methods are used such as, for example, MEMS device 540 is secured in package 542 using epoxy or other adhesive, eutectic bonding, soft solder or other die attach method.

### Example Embodiments

Example 1 includes a method for fabricating a micoelectromechanical (MEMS) structure, the method comprising: etching at least one sacrificial feature in a layer of sacrificial material; bonding the layer of sacrificial material to a glass wafer in a vacuum; heating the glass wafer beyond the glass softening point to vacuum form the glass into the sacrificial layer leaving the at least one sacrificial feature in the glass wafer; polishing the glass wafer to create a glass substrate containing the at least one sacrificial feature; forming recesses in the glass substrate for metallization; forming a semiconductor device layer on the glass substrate; bonding an upper glass wafer containing patterned metallization and recesses to the semiconductor device layer; removing the at least one sacrificial feature to form stress isolation features in the glass wafer.
Example 2 includes the method of Example 1, wherein etching at least one sacrificial feature comprises etching at least one sacrificial feature in a layer of semiconductor material.
Example 3 includes the method of any of Examples 1-2, wherein etching at least one sacrificial feature comprises etching at least one sacrificial feature in a layer of sacrificial material that has a softening temperature above the softening temperature of glass.
Example 4 includes the method of any of Examples 1-3, wherein removing the at least one sacrificial feature forms at least one beam in the glass wafer.
Example 5 includes the method of any of Examples 1-4, wherein removing the at least one sacrificial feature forms a beam that extends from a glass pad formed in the glass wafer, the glass pad used for attaching the MEMS structure in a housing.
Example 6 includes the method of any of Examples 1-5, wherein removing the at least one sacrificial feature forms a glass frame that is coupled to a center glass block by a plurality of glass suspensions.
Example 7 includes the method of any of Examples 1-6, wherein heating the glass wafer comprises heating the glass wafer above the glass softening temperature and below the softening temperature of the sacrificial material.
Example 8 includes the method of any of Examples 1-7, and further comrpising: forming a plurality of bump bonds on the stress isolation features; and coupling the Bump bonds to a housing.
Example 9 includes a method for fabricating a MEMS structure, the method comprising: etching a layer of semiconductor material to form at least one sacrificial feature, the at least one sacrificial feature defining a mold for at least one stress isolation feature for the MEMS structure; bonding the layer of semiconductor material to a glass wafer in an atmosphere approximating a vacuum; heating the glass wafer beyond the glass softening point to vacuum form the glass into the layer of semiconductor material embedding the at least one sacrificial feature in the glass wafer, the glass wafer having first and second opposite sides; polishing the glass wafer on both the first and the second sides to create a smooth glass substrate containing the at least one sacrificial feature; forming recesses in the glass substrate for metallization; forming a semiconductor device layer on the glass substrate; bonding an upper glass wafer containing patterned metallization and recesses to the semiconductor device layer; and removing the at least one sacrificial feature to form the at least one stress isolation feature in the glass substrate.
Example 10 includes the method of Example 9, wherein etching a layer of semiconductor material comprises etching the layer of semiconductor material such that the at least one sacrificial feature defines the at least one stress isolation feature by a void in the glass wafer along at least a portion of the at least one stress isolation feature.
Example 11 includes the method of Example 9, wherein removing the at least one sacrificial feature forms at least one beam that supports the semiconductor device layer.
Example 12 includes the method of Example 9, wherein removing the at least one sacrificial feature forms at least one beam that extends from a glass pad formed in the glass wafer, the glass pad used for attachment to a package.
Example 13 includes the method of Example 9, wherein removing the at least one sacrificial feature forms a glass frame that is coupled to a center glass block by a plurality of glass suspensions.
Example 14 includes a microelectromechanical (MEMS) structure, comprising: a glass substrate layer containing at least one embedded stress isolation feature, the glass substrate also including at least one site configured for coupling the MEMS structure to a package; a semiconductor device layer, formed on the glass substrate layer, and including a MEMS sensor; a top glass layer disposed on the semiconductor device layer.
Example 15 includes the MEMS structure of Example 14, wherein the at least one embedded stress isolation feature comprises at least one beam that supports the semiconductor device layer.
Example 16 includes the MEMS structure of Example 14, wherein the at least one embedded stress isolation feature comprises at least one beam that extends from a glass pad formed in the glass substrate wafer, the glass pad used for a bump bond, epoxy, solder or eutectic bond.
Example 17 includes the MEMS structure of Example 14, wherein the at least one embedded stress isolation feature comprises glass frame that is coupled to a center glass block by a plurality of glass suspensions.
Example 18 includes the MEMS structure of Example 14, and further including a plurality of bonds coupling the glass substrate to the package.
Example 19 includes the MEMS structure of Example 18, and further including a plurality of bump bonds coupled to a glass frame in the glass substrate.
Example 20 includes the MEMS structure of Example 18, and further including a plurality of bump bonds, each bump bond coupled to a pad that is formed integral with one of the at least one embedded strss isolation feature.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A method for fabricating a micoelectromechanical (MEMS) structure, the method comprising:
etching at least one sacrificial feature (104, 504) in a layer of sacrificial material (100, 500);
bonding the layer of sacrificial material to a glass wafer (106, 506) in a vacuum;
heating the glass wafer beyond the glass softening point to vacuum form the glass into the sacrificial layer leaving the at least one sacrificial feature (104, 504) in the glass wafer (110, 510);
polishing the glass wafer to create a glass substrate containing the at least one sacrificial feature;
forming recesses (111) in the glass substrate for metallization;
forming a semiconductor device layer (120) on the glass substrate;
bonding an upper glass wafer (122) containing patterned metallization and recesses to the semiconductor device layer;
removing the at least one sacrificial feature to form stress isolation features including a set of compliant flexures for attachment to a package in the glass wafer.

2. The method of claim 1, wherein etching at least one sacrificial feature comprises etching at least one sacrificial feature in a layer of sacrificial material that has a softening temperature above the softening temperature of glass.

3. The method of claim 1, wherein removing the at least one sacrificial feature forms a beam (105) that extends from a glass pad (107) formed in the glass wafer, the glass pad used for attaching the MEMS structure in a housing.

4. The method of claim 1, wherein removing the at least one sacrificial feature forms a glass frame that is coupled to a center glass block (532) by a plurality of glass suspensions (534).

5. The method of claim 1, wherein heating the glass wafer comprises heating the glass wafer above the glass softening temperature and below the softening temperature of the sacrificial material.

6. The method of claim 1, and further comprising attaching the MEMS structure to a housing (130, 542) using one of bump bonds, epoxy, eutectic bonding, or soft solder.

7. A microelectromechanical (MEMS) structure, comprising:
a glass substrate layer (110, 510) containing at least one monolithic, embedded stress isolation feature including compliant flexures (105, 530), the glass substrate also including at least one site (107, 530) configured for coupling the MEMS structure to a package (130, 542);
a semiconductor device layer (120), formed on the glass substrate layer, and including a MEMS sensor.

8. The MEMS structure of claim 7, wherein the at least one embedded stress isolation feature comprises at least one beam (105) that extends from a glass pad (107) formed in the glass substrate wafer (110), the glass pad used for a bump bond, epoxy, solder or eutectic bond.

9. The MEMS structure of claim 7, wherein the at least one embedded stress isolation feature comprises glass frame (530) that is coupled to a center glass block (532) by a plurality of glass suspensions (534).

10. The MEMS structure of claim 7, and further including a top glass layer (122) disposed on the semiconductor device layer.

## Patentansprüche

1. Verfahren zum Herstellen einer mikroelektromechanischen bzw. MEMS-Struktur, das Verfahren umfassend:
Ätzen mindestens eines Opfermerkmals (104, 504) in einer Schicht von Opfermaterial (100, 500);
Bonden der Schicht von Opfermaterial an einen Glaswafer (106, 506) in einem Vakuum;
Erwärmen des Glaswafers über den Glaserweichungspunkt hinaus, um das Glas in die Opferschicht zu vakuumformen, wobei das mindestens eine Opfermerkmal (104, 504) in dem Glaswafer (110, 510) gelassen wird;
Polieren des Glaswafers, um ein Glassubstrat zu erzeugen, das das mindestens eine Opfermerkmal enthält;
Bilden von Vertiefungen (111) in dem Glassubstrat für Metallisation;
Bilden einer Halbleitervorrichtungsschicht (120) auf dem Glassubstrat;
Bonden eines oberen Glaswafers (122), der gemusterte Metallisation und Vertiefungen enthält, an die Halbleitervorrichtungsschicht;
Entfernen des mindestens einen Opfermerkmals, um Stressisolationsmerkmale, die einen Satz von konformen Flexuren zum Anbringen an eine Packung enthalten, in dem Glaswafer zu bilden.

2. Verfahren nach Anspruch 1, wobei Ätzen mindestens eines Opfermerkmals umfasst, mindestens ein Opfermerkmal in einer Schicht von Opfermerkmal, das eine Erweichungstemperatur über der Erweichungstemperatur von Glas aufweist, zu ätzen.

3. Verfahren nach Anspruch 1, wobei Entfernen des mindestens einen Opfermerkmals einen Balken (105) bildet, der sich von einer in dem Glaswafer gebildeten Glasunterlage (107) erstreckt, wobei die Glasunterlage zum Anbringen der MEMS-Struktur in einem Gehäuse verwendet wird.

4. Verfahren nach Anspruch 1, wobei Entfernen des mindestens einen Opfermerkmals einen Glasrahmen bildet, der durch eine Vielzahl von Glasstützen (534) an einen zentralen Glasblock (532) gekoppelt ist.

5. Verfahren nach Anspruch 1, wobei Erwärmen des Glaswafers umfasst, den Glaswafer über die Glaserweichungstemperatur und unter der Erweichungstemperatur des Opfermaterials zu erwärmen.

6. Verfahren nach Anspruch 1 und ferner umfassend, die MEMS-Struktur unter Verwendung eines von Hügelbonds, Epoxid, eutektischem Bonden oder Weichlot an ein Gehäuse (130, 542) anzubringen.

7. Mikroelektromechanische bzw. MEMS-Struktur, umfassend:
eine Glassubstratschicht (110, 510), enthaltend mindestens ein monolithisches, eingebettetes Stressisolationsmerkmal, das konforme Flexuren (105, 530) enthält, wobei das Glassubstrat außerdem mindestens eine Stelle (107, 530) enthält, die für Kopplung der MEMS-Struktur an eine Packung (130, 542) konfiguriert ist;
eine Halbleitervorrichtungsschicht (120), gebildet auf der Glassubstratschicht und enthaltend einen MEMS-Sensor.

8. MEMS-Struktur nach Anspruch 7, wobei das mindestens eine eingebettete Stressisolationsmerkmal mindestens einen Balken (105) umfasst, der sich von einer in dem Glassubstratwafer (110) gebildeten Glasunterlage (107) erstreckt, wobei die Glasunterlage für einen Hügelbond, Epoxid, Lot oder eutektischen Bond verwendet wird.

9. MEMS-Struktur nach Anspruch 7, wobei das mindestens eine eingebettete Stressisolationsmerkmal einen Glasrahmen (530) umfasst, der durch eine Vielzahl von Glasstützen (534) an einen zentralen Glasblock (532) gekoppelt ist.

10. MEMS-Struktur nach Anspruch 7 und ferner enthaltend eine obere Glasschicht (122), die auf der Halbleitervorrichtungsschicht angeordnet ist.

## Revendications

1. Procédé de fabrication d'une structure microélectromécanique (MEMS), le procédé comprenant les étapes suivantes :
graver au moins un élément sacrificiel (104, 504) dans une couche de matériau sacrificiel (100, 500) ;
assembler la couche de matériau sacrificiel à une tranche de verre (106, 506) sous vide ;
chauffer la tranche de verre au-delà du point de ramollissement du verre pour former sous vide le verre à l'intérieur de la couche sacrificielle en laissant l'au moins un élément sacrificiel (104, 504) dans la tranche de verre (110, 510) ;
polir la tranche de verre pour créer un substrat de verre contenant l'au moins un élément sacrificiel ;
former des encoches (111) dans le substrat de verre pour métallisation ;
former une couche de dispositif semi-conducteur (120) sur le substrat de verre ;
assembler une tranche de verre supérieure (122) contenant une structure de métallisation et des encoches à la couche de dispositif semi-conducteur ;
retirer l'au moins un élément sacrificiel pour former des éléments d'isolement des contraintes comportant un ensemble de flexions souples pour fixation à un boîtier dans la tranche de verre.

2. Procédé de la revendication 1, dans lequel la gravure d'au moins un élément sacrificiel comprend la gravure d'au moins un élément sacrificiel dans une couche de matériau sacrificiel qui a une température de ramollissement plus élevée que la température de ramollissement du verre.

3. Procédé de la revendication 1, dans lequel le retrait de l'au moins un élément sacrificiel forme une poutre (105) qui s'étend depuis une plage de verre (107) formé dans la tranche de verre, la plage de verre étant utilisée pour fixer la structure MEMS dans un boîtier.

4. Procédé de la revendication 1, dans lequel le retrait de l'au moins un élément sacrificiel forme un cadre de verre qui est couplé à un bloc de verre central (532) par une pluralité de suspensions de verre (534).

5. Procédé de la revendication 1, dans lequel le chauffage de la tranche de verre comprend le chauffage de la tranche de verre au-dessus de la température de ramollissement du verre et au-dessous de la température de ramollissement du matériau sacrificiel.

6. Procédé de la revendication 1, et comprenant en outre la fixation de la structure MEMS à un boîtier (130, 542) au moyen de plots de connexion, d'un époxy, d'une liaison eutectique, ou d'une brasure tendre.

7. Structure microélectromécanique (MEMS), comprenant :
une couche de substrat de verre (100, 510) contenant au moins un élément d'isolement des contraintes monolithique, intégré comportant des flexions souples (105, 530), le substrat de verre comportant également au moins un site (107, 530) configuré pour coupler la structure MEMS à un boîtier (130, 542) ;
une couche de dispositif semi-conducteur (120) formée sur la couche de substrat de verre, et comportant un capteur MEMS.

8. Structure MEMS de la revendication 7, dans laquelle l'au moins un élément d'isolement des contraintes intégré comprend au moins une poutre (105) qui s'étend depuis une plage de verre (107) formée dans la tranche de substrat de verre (110), la plage de verre étant utilisée pour un plot de connexion, un époxy, une brasure ou une liaison eutectique.

9. Structure MEMS de la revendication 7, dans laquelle l'au moins un élément d'isolement des contraintes intégré comprend un cadre de verre (530) qui est couplé à un bloc de verre central (532) par une pluralité de suspensions de verre (534).

10. Structure MEMS de la revendication 7, et comportant en outre une couche de verre supérieure (122) disposée sur la couche de dispositif semi-conducteur.
